# EUROPÄISCHE PATENTSCHRIFT

(11) **EP 0 292 848 B1**
(45) Veröffentlichungstag und Bekanntmachung des Hinweises auf die Patenterteilung: **30.06.1993**
(21) Anmeldenummer: 88107927.1
(22) Anmeldetag: 18.05.1988
(51) Int. Cl.: H01L 23/48, H01L 23/52, H01L 25/04

(54) **Leistungshalbleitermodul und Verfahren zur Herstellung des Moduls**
Semiconductor power module and method of manufacturing it
Module de puissance à semi-conducteur et son procédé de fabrication

(30) Priorität: 23.05.1987 DE 3717489
(43) Veröffentlichungstag der Anmeldung: 30.11.1988
(73) Patentinhaber: Asea Brown Boveri Aktiengesellschaft, 68309 Mannheim (DE)
(72) Erfinder: Neidig, Arno, Dr., D-6831 Plankstadt (DE); Hettmann, Hubert, D-6832 Hockenheim (DE)
(74) Vertreter: Rupprecht, Klaus, Dipl.-Ing.

(56) Entgegenhaltungen:
- EP-A- 0 034 001
- EP-A- 0 155 473
- DE-A- 3 028 178
- DE-A- 3 528 427
- FR-A- 2 527 837
- UND- ODER- NOR + STEUERUNGSTECHNIK. vol. 15, no. 3, 1985, MÜNCHEN,DE Seiten 32 - 33; A.NEIDIG: "Leistungshalbleiter-Module in neuer Technologie "

## Beschreibung

Die Erfindung bezieht sich auf ein Leistungshalbleitermodul nach dem Oberbegriff des Anspruchs 1 sowie auf ein Verfahren zur Herstellung eines solchen Moduls.

Ein solches Leistungshalbleitermodul ist aus der Patentanmeldung DE-A-36 04 313 und auch das DE-A-30 28 178 bekannt. Das bekannte Leistungshalbleitermodul besteht aus einem Kunststoffgehäuse, das am Boden offen ist. Als Bodenflache ist ein Keramiksubstrat eingesetzt, das auf seiner Oberseite eine strukturierte Metallisierung aufweist, auf die Leistungshalbleiterbauelemente und elektrische Verbindungselemente für modulinterne Verbindungen aufgelötet sind. Außerdem sind auf der Metallisierung des Substrats Anschlußelemente für äußere Laststrom führende Hauptanschlüsse angelötet. Die Steueranschlüsse sind sogenannte außenliegende Anschlüsse, weil ihre Projektion auf die Ebene des Substrats außerhalb der Substratfläche liegt. Die Steueranschlüsse werden dort in einem zweiten Lötschritt angelötet oder nach der Herstellung von Drahtverbindungen mit Drahtbondern in Steckhülsen eingesteckt. Die Anschlußlaschen für die Hauptanschlüsse werden jedoch ebenso wie auch bei anderen bekannten Modulen im ersten Lötschritt senkrecht auf dem Substrat stehend angelötet. Dabei ist eine aufwendige Lötform erforderlich, die die Anschlußlaschen während des Lötvorganges an der gewünschten Stelle fixieren und am Kippen hindern.

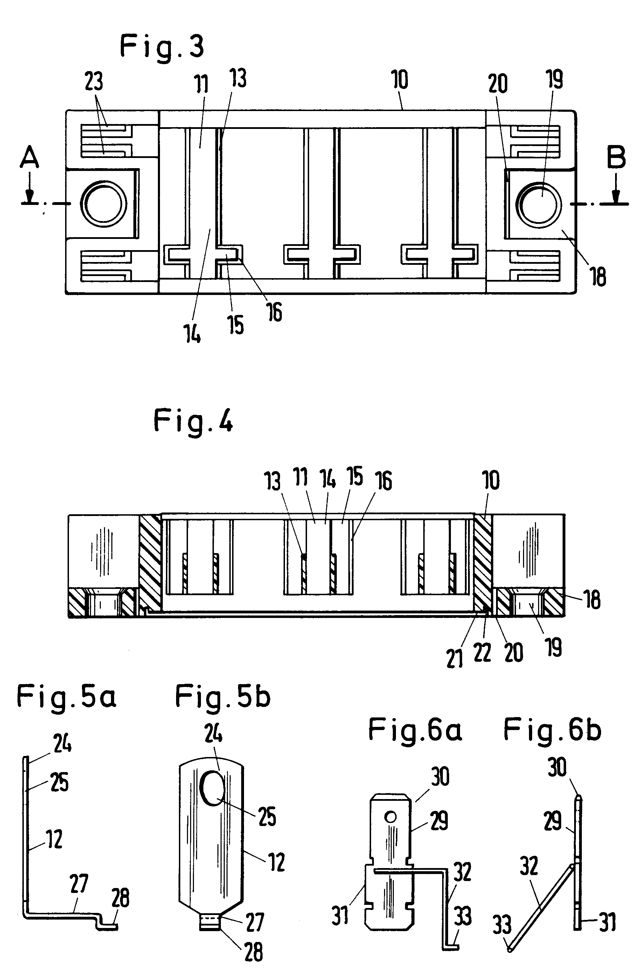

Aus electronic design vom 8. Jan. 1987, Seite 156, Fig. 4e ist eine Modul-Herstellung bekannt, wobei Anschlußelemente liegend angelötet werden. Dadurch wird einerseits nach dem Löten noch Zugang für ein Bondwerkzeug ermöglicht und außerdem eine Lötform entbehrlich gemacht oder zumindest wird nur eine einfache Justiervorrichtung benötigt. Allerdings müssen die Anschlußlaschen nach dem Löten von einer Rahmenstruktur herausgetrennt und nach oben gebogen werden. Dieses ist ein gewisser Aufwand und kann die Lötstellen mechanisch belasten.

Die der Erfindung zugrundeliegende Aufgabe besteht darin, ein Leistungshalbleitermodul mit einer solchen Gestaltung anzugeben, die zu einer Vereinfachung der Herstellung führt und dabei insbesondere Positionier- oder Justierhilfen für die Bestückungsteile entbehrlich macht.

Diese Aufgabe wird bei einem Leistungshalbleitermodul nach dem Oberbegriff des Anspruchs 1 durch dessen kennzeichnende Merkmale gelöst.

Vorteilhafte Ausgestaltungen sind in den Unteransprüchen angegeben. Außerdem sind in den Ansprüchen 10 und 11 Verfahren zur Herstellung solcher Module angegeben.

Nach einer Variante der Erfindung wird vorgeschlagen, die Herstellung in zwei Lötschritten bei unterschiedlicher Löttemperatur durchzuführen, wobei im ersten Schritt noch keine äußeren Anschlußelemente angebracht werden. Das im ersten Schritt bestückte und gelötete Substrat ist gut zugänglich für Bondwerkzeuge und Prüfeinrichtungen. Im zweiten Lötschritt wird ein entsprechend gestalteter Teil des Kunststoffgehäuses als Lötform benutzt. Das heißt Anschlußelemente werden im Kunststoffgehäuse exakt justiert. Das Kunststoffgehäuse ist temperaturbeständig ausgeführt, so daß eine zweite Lötung im Durchlaufofen durchgeführt werden kann, wobei nur eine vorteilhaft geringe Durchlaufzeit erforderlich ist, weil das Kunststoffgehäuse eine geringe Masse besitzt. Alternativ kann die zweite Lötung vorteilhafterweise auch so durchgeführt werden, daß nur die Fußpunkte der Anschlußelemente kurzzeitig auf eine für die Lötung erforderliche Temperatur erwärmt werden. Dabei wird das Kunststoffgehause thermisch am geringsten belastet und das Weichlot darf den gleichen Schmelzpunkt haben wie bei der ersten Lötung. Dabei können gegebenenfalls auch Kunststoffgehäuse verwendet werden, die lediglich den sonst gebräuchlichen Bedingungen bezüglich Temperaturbeständigkeit genügen. Nach der zweiten Lötung, die bei niedrigerer Temperatur als die erste Lötung durchgeführt wird, wird das Modul in üblicher Weise vergossen und es wird ein Deckel mit einem Schnappverschluß aufgesetzt. Danach können durch an den Laschenquerschnitt angepaßte schmale Öffnungen im Deckel ragende Anschlußlaschen einfach umgebogen werden.

Nach einer zweiten Variante wird für ein Modul, das keinen Drahtbondschritt erfordert, vorgeschlagen, ein temperaturbeständiges Kunststoffgehäuse vorzusehen, das mit Ausnehmungen versehen ist, in denen Bestückungsteile wie Halbleiterchips, Verbindungsclips und Stecker für äußere Anschlüsse justiert und während eines Lötschrittes gehalten werden.

Eine nähere Beschreibung der Erfindung erfolgt anhand der in der Zeichnung dargestellten Ausführungsbeispiele.

Es zeigen:
- Fig. 1: Schaltbild des in den Figuren 2 bis 9 dargestellten Leistungshalbleitermoduls,
- Fig. 2: Draufsicht auf ein bestücktes Keramiksubstrat,
- Fig. 3: Draufsicht auf einen Kunststoffgehäuserahmen,
- Fig. 4: Schnitt durch den in Fig. 3 dargestellten Gehäuserahmen,
- Fig. 5a: Seitenansicht einer Anschlußlasche,
- Fig. 5b: Frontanschicht der Anschlußlasche,
- Fig. 6a: Frontansicht eines Steckers mit angeschweißtem Verbindungsdraht,
- Fig 6b: Seitenansicht des Steckers mit Draht,
- Fig. 7: Draufsicht auf den Gehäuserahmen mit in den Boden eingesetztem Keramiksubstrat und nach Bestückung mit Anschlußlaschen und Steckern,
- Fig. 8: Draufsicht auf das fertige mit einem Kunststoffdeckel versehene Leistungshalbleitermodul,
- Fig. 9: Seitenansicht des fertiggestellten Leistungshalbleitermoduls,
- Fig. 10 und 11: Substrat zu einen in den Figuren 15 und 16 dargestellten Einphasengleichrichter-Modul nach einem zweiten Ausführungsbeispiel,
- Fig. 12: Bestückungsteile für das Modul des zweiten Ausführungsbeispiels,
- Fig. 13 und 14: Kunststoffgehäuse für das Modul des zweiten Ausführungsbeispiels,
- Fig. 15: bestücktes Modul,
- Fig. 16: vergossenes Modul.

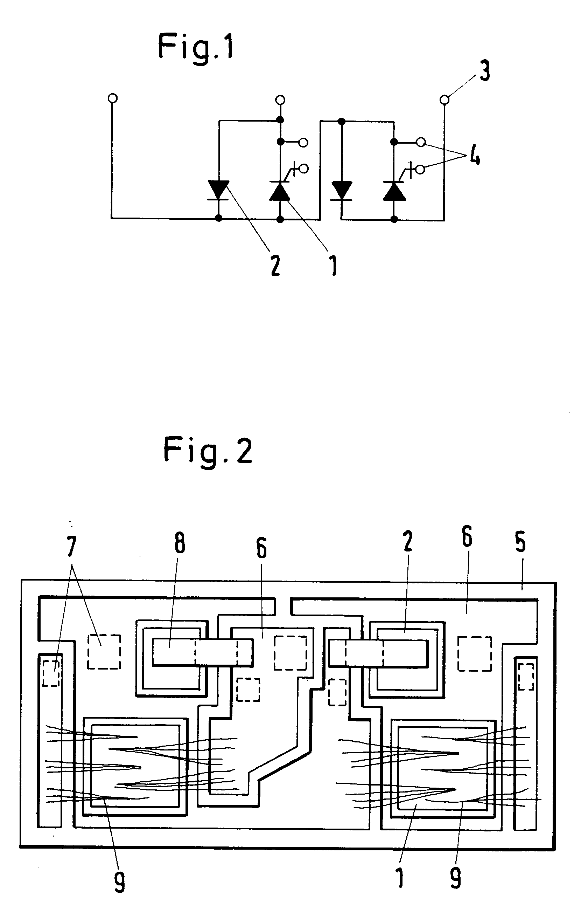

Fig. 1 zeigt zum besseren Verständnis des in den Figuren 2 bis 9 dargestellten ersten Ausführungsbeispiels eines Leistungshalbleitermoduls das zugrundeliegende Schaltbild. Daraus geht hervor, daß im Leistungshalbleitermodul zwei abschaltbare Thyristoren 1 und zwei Dioden 2 enthalten sind und daß das Modul drei Hauptanschlüsse 3 und vier Steueranschlüsse 4 enthält.

Fig. 2 zeigt ein Keramiksubstrat 5 aus Aluminiumoxid, das nach einem Direktbondingverfahren aufgebrachte Kupferflächen 6 als Leiterbahnen enthält. Auf die Kupferflächen 6 sind die abschaltbaren Thyristoren 1 und Dioden 2 aufgelötet. Es sind Lotflächen 7 angedeutet, also Flächen auf den Kupferflächen 6, die im ersten Herstellungsschritt mit Lotmaterial vorbenetzt werden. Auf diesen Lotflächen 7 werden später Anschlußelemente aufgelötet. In Fig. 2 sind weiterhin aufgelötete Clips 8 zu erkennen, mit denen elektrische Verbindungen zwischen Dioden 2 und Kupferflächen 6 hergestellt sind. Schließich sind Drahtverbindungen 9 zwischen den Thyristoren 1 und Kupferflächen 6 dargestellt, die durch Ultraschall-Dickdrahtbonden hergestellt sind.

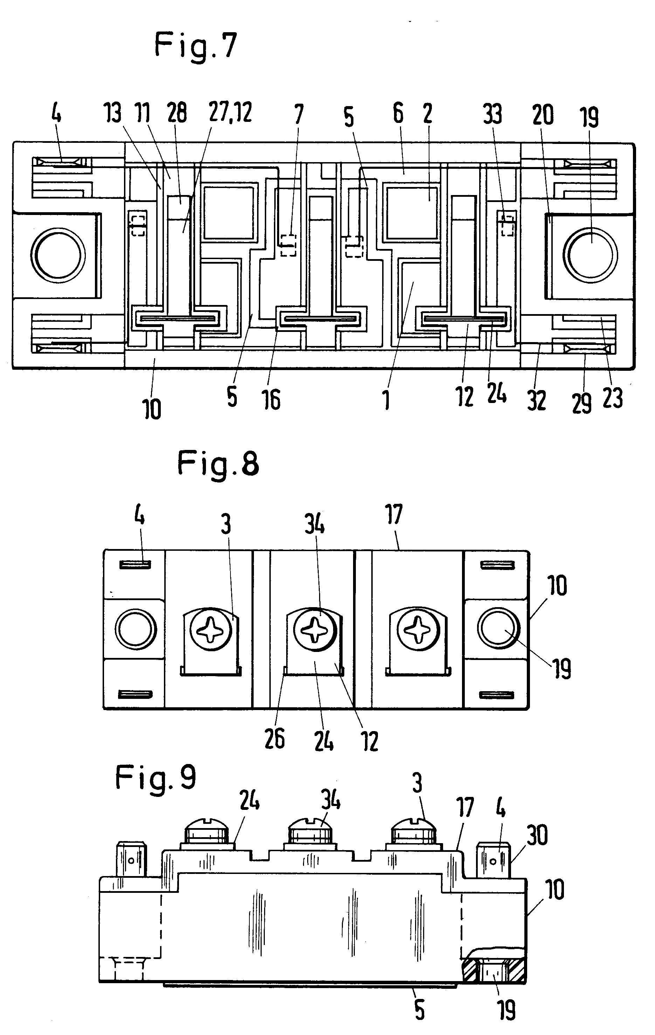

Fig. 3 zeigt eine Draufsicht auf einen Gehäuserahmen 10 aus einem temperaturbeständigen Kunststoff. Das als Gehäuserahmen 10 bezeichnete Gehäuseteil weist als erfindungswesentliche Gestaltung Zwischenwände 13 zur Bildung von Führungsschächten 11 auf, in die während der Modulherstellung in den Fig. 5a und 5b dargestellte Anschlußlaschen 12 eingesetzt werden, wie in Fig. 7 dargestellt.

Die Form der durch die Zwischenwände 13 gebildeten Führungsschächte 11 wird durch zusätzliche Betrachtung der Figur 4 deutlicher. In Fig. 4 ist ein Schnitt durch die in Fig. 3 eingetragene Ebene A-B des Gehäuserahmens 10 dargestellt. Aus den Fig. 3 und 4 ist ersichtlich, daß ein Führungsschacht 11 jeweils aus einem schmalen Schachtteil 14 und einem breiten Schachtteil 15 besteht. Fig. 4 zeigt außerdem, daß der breite Schachtteil 15 höher ist als der schmale Schachtteil 14. Der breite Schachtteil 15 ist durch eine Anformung 16 an die Zwischenwand 13 gebildet. Zwei Zwischenwände 13 mit Anformung 16 sind jeweils spiegelbildlich ausgeführt und in einem geeigneten Abstand zueinander angeordnet, so daß kreuzförmige Führungsschächte 11 mit den schmalen und breiten Teilen 14 und 15 entstehen. Wie aus Fig. 4 ersichtlich ist, befinden sich die Zwischenwände 13 nur etwa in einem mittleren Drittel der Höhe des Gehäuserahmens 10. Unterhalb der Zwischenwände 13 bleibt dadurch ein Raum frei für die in Fig. 4 nicht dargestellten Bauelemente 1,2 auf dem in der Bodenebene des Rahmens 10 einzusetzenden Substrat 5. Der durch die Anformungen 16 gebildete breite Schachtteil 15 reicht bis zur Oberkante des Rahmens 10, auf den ein in den Fig. 8 und 9 abgebildeter Gehäusedeckel 17 aufgeschnappt wird.

In den Fig. 3 und 4 sind weitere, jedoch aus dem Stand der Technik bekannte Einzelheiten des Gehäuserahmens 10 zu entnehmen. In den Gehäuserahmen 10 sind Befestigungsflansche 18 angeformt, mit Bohrungen 19 für Befestigungsschrauben. Im Bereich der Flansche 18 sind Schlitze 20 vorgesehen, um die Ubertragung von mechanischen Spannungen aus dem Bereich der Befestigungsschrauben auf das Substrat 5 zu verhindern. An der Unterseite des Rahmens 10 ist eine Ausnehmung 21 zur Aufnahme des Substrats 5 vorgesehen sowie eine Nut 22 in der Ausnehmung 21 zur Aufnahme von Klebstoffresten.

In der in Fig. 3 gezeigten Draufsicht sind außerdem angeformte Taschen 23 zu sehen, die vorgesehen sind zur Führung von in Fig. 6a dargestellten Steckern 29, die die Steueranschlüsse 4 bilden.

Die Fig. 5a und 5b zeigen die bereits erwähnten Anschlußlaschen 12 in Seiten- und Frontansicht. Die Laschen 12 weisen in einem oberen Laschenteil 24 ein Langloch 25 auf. Dieser obere Laschenteil 24 ragt nach der Montage des Gehäusedeckels 17 durch eine schmale Öffnung 26 des Deckels 17 und wird dort umgebogen, wie in Fig. 8 dargestellt.

Die in den Fig. 5a und 5b gezeigte Anschlußlasche 12 weist außer dem breiten oberen Laschenteil 24 mit dem Langloch 25 einen angewinkelten schmalen Verbindungsteil 27 mit einem durch Z-förmige Abwinkelung gebildeten Lötanschlußteil 28 auf.

In den Fig. 6a und 6b sind die erwähnten Stecker 29 für die Steueranschlüsse 4 dargestellt. Sie weisen einen Flachsteckerteil 30 und einen Fußteil 31 auf, mit dem sie in eine der Taschen 23 des Gehäuserahmens 10 gesteckt werden. Am Fußteil 31 ist ein zweimal abgewinkeltes Drahtstück 32 angeschweißt. Das Drahtstück 32 ist so gebogen, daß sein freies Ende 33 nach dem Einsetzen des Steckers 29 in eine Tasche 23 auf einer vorgesehenen Lotfläche 7 auf dem Substrat 5 aufliegt.

In Fig. 7 ist nochmals eine Draufsicht auf den Gehäuserahmen 10 dargestellt, jedoch nachdem in der Bodenfläche des Rahmens 10 das bestückte Substrat 5 eingeklebt und die Anschlußlaschen 12 in die Führungsschächte 11 eingelegt und die Stecker 29 in die Tasche 23 eingesteckt sind. Nicht dargestellt sind in Fig. 7 der Ubersichtlichkeit wegen die Drahtverbindungen 9 und die Clips 8, die in Fig. 2 zu sehen sind.

Fig. 8 zeigt eine Draufsicht auf den Gehäusedeckel 17, der auf dem Gehäuserahmen 10 aufgeschnappt ist. Die drei durch die schmalen Öffnungen 26 im Deckel 17 ragenden oberen Laschenteile 24 sind umgebogen. Unterhalb des Langlochs 25 im Laschenteil 24 sind Muttern eingelegt, in die Schrauben 34 zur Bildung der Hauptanschlüsse 3 eingeschraubt sind. Fig. 9 zeigt schließlich noch eine Seitenansicht des fertigen Moduls.

Ein Verfahren zur Herstellung des in der Zeichnung dargestellten Leistungshalbleitermoduls wird nachstehend beschrieben.

Es wird von einem Substrat 5 ausgegangen, das aus Al₂O₃-Keramik besteht und mit Kupferflächen 6 als Leiterbahnen versehen ist. Die Verbindung der Kupferflächen 6 mit dem Keramiksubstrat 5 erfolgt nach einem bekannten Direktverbindungsverfahren. Auf die Kupferflächen 6 werden Thyristoren 1, hier GTO-Thyristoren, und Dioden 2 sowie Clips 8 aufgelötet. Diese Lötung erfolgt mit einem hochschmelzenden Lot bei etwa 300°C, z.B. im Durchlaufofen. Außerdem werden in Fig. 2 mit 7 bezeichnete Flächen mit niedrigschmelzendem Lotmaterial, z.B.PbSn 60 zur Vorbereitung eines späteren Lötschritts vorbenetzt. Zwischen Kathoden- und Gatefingern auf den abschaltbaren Thyristoren 1 und Kupferflächen 6 werden Drahtverbindungen 9 durch Ultraschall-Drahtbonden hergestellt. Selbstverständlich können auch zur Kontaktierung der Dioden 2 anstelle der Clips 8 Drahtverbindungen 9 benutzt werden. Damit ist das in Fig. 2 dargestellte bestückte Substrat hergestellt und kann bezüglich wichtiger elektrischer Parameter vorgeprüft werden.

Das soweit bestückte Substrat 5 wird in die vorgesehene Ausnehmung 21 in der Bodenfläche des in den Fig. 3 und 4 dargestellten Gehäuserahmens 10 mit Hilfe eines elastischen Silikonkautschuks eingeklebt, der mechanische Spannungen zwischen Substrat und Gehäuse vermeidet. Es ist jedoch alternativ auch möglich, das Substrat 5 zuerst auf eine nicht dargestellte massive Bodenplatte aus Kupfer zu löten und dann erst den Gehäuserahmen 10 aufzukleben.

Der Gehäuserahmen 10 besteht aus einem temperaturbeständigen Kunststoff, um bei dem folgenden zweiten Lötschritt nicht zerstört zu werden. Geeignet ist z.B. ein teilkristallines thermoplastisches Polyester mit einem Schmelzpunkt zwischen 200°C und 260°C.

Nach dem Aushärten des Klebstoffes werden die in den Fig. 5a und 5b dargestellten Anschlußlaschen 12 in die Führungsschächte 11 eingesetzt, wie in Fig. 7 gezeigt. Die Führungsschächte 11 wirken im zweiten Lötschritt als Lötform. Der Lotanschlußteil 28 der Anschlußlaschen 12 liegt jeweils auf einer Lotfläche 7 auf den Kupferflächen 6 auf. Um eine gute Benetzung zu gewährleisten, können die Anschlußlaschen zuvor vernickelt, versilbert oder verzinnt werden.

Außerdem werden, wie in Fig. 7 dargestellt, die in den Fig. 6a und 6b gezeigten Stecker 29 in die vorgesehenen Taschen 23 gesteckt und die angeschweißten Drahtstücke 32 so ausgerichtet, daß deren freies Ende 33 jeweils auf einer Lotfläche 7 aufliegt. Die Drahtstücke 32 können vernickelt, versilbert oder verzinnt sein für eine optimale Lötung. Die Drahtstücke 32 werden als Verbindungselemente zwischen Kupferflächen 6 und Stecker 29 bevorzugt, weil sich durch einfaches Biegen des Drahtes eine Anpassung an unterschiedliche Layout des mit Kupferflächen 6 versehenen Substrats 5 realisieren läßt.

Es ist anzumerken, daß je nach benötigter Stückzahl und Wirtschaftlichkeit einige Variationen möglich sind. So kann anstelle der Drahtstücke 32 ein Verbindungselement schon beim Stanzen der Stecker 29 direkt angeformt werden und in dieser Ausführung vom Steckerhersteller bezogen werden. Anstelle der vorgesehenen Lotflächen 7 auf den Kupferflächen 6 kann es auch genügen, nur den Lötanschlußteil 28 der Anschlußlaschen 12 sowie die freien Enden 33 der Drahtstücke 32 mit Tropfen von flußmittelhaltiger Lotpaste zu versehen und zu trocknen. Es ist auch möglich, den Gehäuserahmen 10 bereits mit durch eingesetzten, fest in den Rahmen 10 verbundenen Laschen 12 und Steckern 29 vom Lieferanten zu beziehen, so daß diese Teile nicht mehr eingelegt werden müssen.

Die Verbindung der Anschlußlaschen 12 und Drahtstücke 32 mit den Kupferflächen 6 erfolgt in einem zweiten Lötschritt. Wenn vorbenetzte Lotflächen 7 vorgesehen waren, erfolgt der Lötprozeß zweckmäßig in einem Durchlaufofen mit einer maximalen Löttemperatur von 220°C in reduzierender Atmosphäre. In einem Durchlaufofen mit Infrarotlampen-Heizung lassen sich z.B. kurze Lötzeiten von 1 bis 2 Minuten erzielen, da das Kunststoffgehäuse 10 und das Substrat 5 nur eine geringe Masse aufweisen. Ebenso können Dampfphasenlötbäder eingesetzt werden, z.B. mit FC-70 von der Firma 3M als Siedeflüssigkeit mit Siedepunkt 215°C. Es sind jedoch auch andere Lötverfahren anwendbar, z.B. Löten durch punktförmiges Erwärmen der Lötstelle mittels Laserstrahl oder mittels sogenanntem Impulslöten mit widerstands-beheizten Druckstempeln. Dabei werden die Kunststoffteile thermisch am geringsten belastet, so daß auch weniger temperaturstabile Kunststoffe verwendet werden können.

Als letzter Fertigungsschritt wird das so weit fertiggestellte Modul mit Silikonweichverguß und anschließend mit Epoxydharz in bekannter Weise ausgegossen und es wird ein Gehäusedeckel 17 aus Kunststoff aufgeschnappt. In den Deckel 17 werden an den Stellen der Hauptanschlüsse 3 in vorgesehene Vertiefungen Muttern eingelegt und die aus dem Deckel herausragenden oberen Laschenteile 24 so umgebogen, daß sich das Langloch 25 im Laschenteil 24 jeweils über einer Mutter befindet und eine Schraube 34 eingeschraubt werden kann.

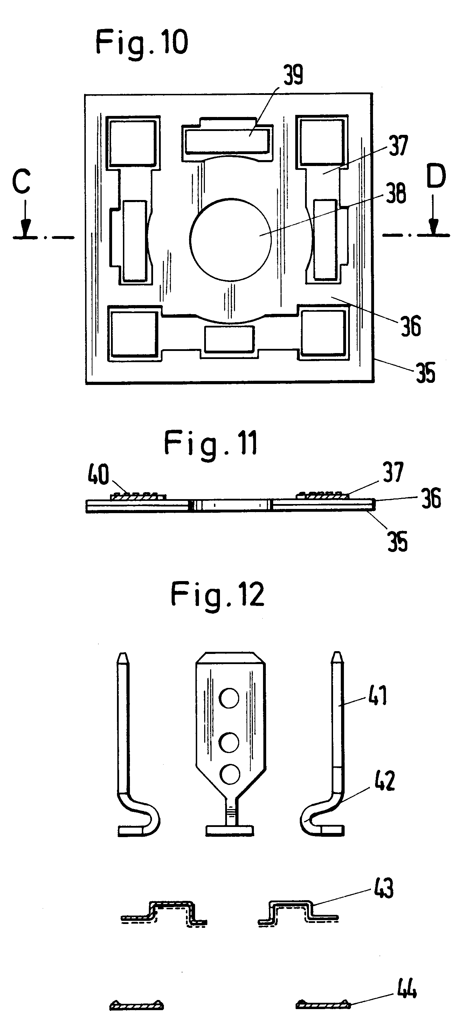

Ein zweites Ausführungsbeispiel ist in den Figuren 10 bis 16 dargestellt. Dabei handelt es sich um ein Leistungshalbleitermodul, bei dem das Kunststoffgehäuse nicht nur als Lötform für die Montage von Außenanschlüssen wirkt, sondern auch als Lötform für Halbleiterchips und Clips für modulinterne Verbindungen. Das dargestellte Modul ist in einer ähnlichen Ausführung bereits aus der deutschen Patentanmeldung 36 10 288 bekannt. Bei dem bekannten Modul ist jedoch das Gehäuse nicht als Lötform verwendbar. Das Modul stellt die Realisierung eines Einphasengleichrichters dar.

Fig. 10 zeigt eine Draufsicht auf ein Substrat 35, das in diesem Beispiel nicht aus Keramik besteht, sondern aus einer Metallplatte, z.B. einem Aluminiumblech, das mit einer Isolierschicht 36 beschichtet ist, die z.B. aus Polyimid oder Epoxidharz besteht. Die Isolierschicht 36 besitzt eine ausreichende elektrische Isolierfähigkeit (z.B. Spannungsfestigkeit 3kV über einer Sekunde Dauer) bei gleichzeitig guter Wärmeleitung. Zusätzlich ist eine strukturierte Kupferschicht 37 auf die Isolierschicht 36 aufgebracht. Solche Substrate aus Metall mit Isolierschicht und Kupferschichten werden auf dem Markt angeboten, z.B. von Fa. Denka das Produkt Hitt-Plate. Eine Beschreibung des Verfahrens zur Herstellung solcher Substrate ist deshalb entbehrlich.

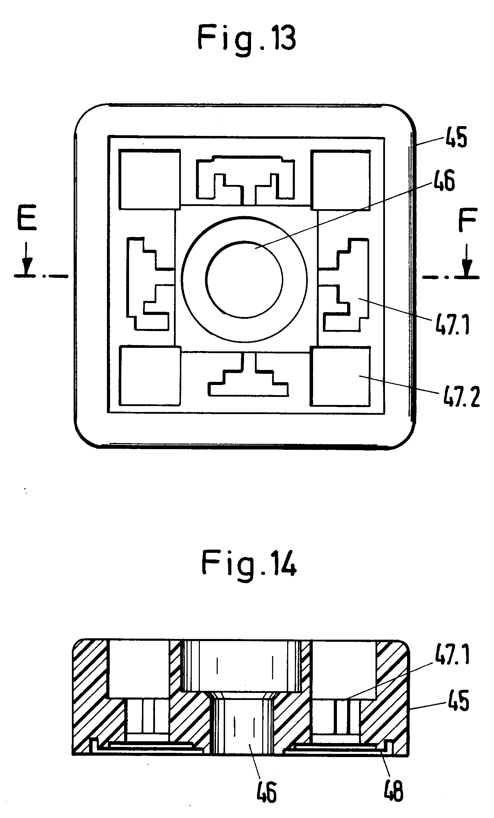

Das Substrat 35 ist im zweiten Ausführungsbeispiel quadratisch ausgeführt und weist in der Mitte eine Öffnung 38 auf, da das Modul für eine Befestigung mit einer zentralen, also in der Mitte angeordneten Schraube vorgesehen ist. In der Draufsicht der Fig. 10 sind weiterhin Flächen 39 zu erkennen, die mit Lotpaste 40 (Fig. 11) bedruckt sind. Die Flächen 39 sind diejenigen Flächen, auf die in einem späteren Arbeitsgang Bestückungsteile aufgelötet werden sollen. Die Flächen 39 werden z.B. nach einem Siebdruckverfahren mit einer Lotpaste 40 bedruckt, die Flußmittel enthält. Die Lotpaste 40 wird angetrocknet. Dieser Trocknungsprozeß kann gleichzeitig mit einem anderen Prozeß erfolgen, nämlich dem Härten des Klebstoffs, mit dem das Substrat 35 in ein Kunststoffgehäuse 45 (Fig. 14) eingeklebt wird.

Fig. 11 zeigt das Substrat 35 nach einem Schnitt durch die in Fig. 10 eingetragene Schnittebene C-D. Das Substrat 35 kann z.B. aus einer etwa 1mm dicken Aluminiumplatte bestehen, die Isolierschicht 36 70µn dick sein und die Kupferschicht 37 etwa 35µm dick.

Fig.12 zeigt Teile mit denen das Substrat bestückt werden soll, nämlich Flachstecker 41 mit Dehnungsbogen 42, Clips 43 für modulinterne Verbindungen und Halbleiterchips 44.

Fig. 13 zeigt eine Draufsicht auf ein Kunststoffgehäuse 45. Fig. 14 zeigt einen Schnitt durch die in Fig. 13 eingetragene Schnittebene E-F durch das Kunststoffgehäuse 45.

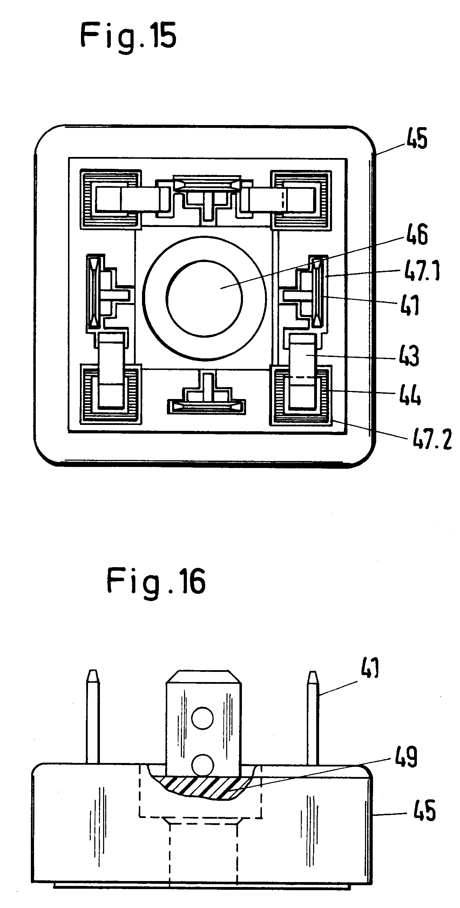

Das Kunststoffgehäuse 45 enthält außer einer zentralen Bohrung 46 für eine Befestigungsschraube speziell geformte Ausnehmungen 47.1 und 47.2, die zur Positionierung der Bestückungsteile 41, 43 und 44 und zur Führung während des Lötprozesses vorgesehen sind. Die Ausnehmungen 47.1 sind dabei geeignet zur Führung der Stecker 41 und die Ausnehmungen 47.2 zur Führung der Halbleiterchips 44. Die Clips 43 werden jeweils durch eine Ausnehmung 47.1 und eine Ausnehmung 47.2 geführt, wie aus Fig. 15 hervorgeht. Das Kunststoffgehäuse 45 muß ebenso wie das im ersten Ausführungsbeispiel beschriebene Gehäuse 10 temperaturbeständig sein. An der Unterseite des Kunststoffgehäuses 45 ist eine Vertiefung 48 vorgesehen, in die das Substrat 35 eingesetzt wird.

Das Substrat 35 kann z.B. mit einem Silikonkautschuk in das Kunststoffgehäuse 45 eingeklebt werden, der bei erhöhter Temperatur härtet. Danach erfolgt das Bestücken des Moduls von oben durch die Ausnehmungen 47.1 und 47.2 im Gehäuse. Zuerst werden die Halbleiterchips 44 eingesetzt, dann die Clips 43 und zuletzt die Flachstecker 41. Diese Teile liegen somit mit ihren gegebenenfalls vorbeloteten Lötflächen auf den zuvor mit Lotpaste 40 versehenen Flächen 39 auf dem Substrat 35 auf und werden durch die Ausnehmungen 47.1 und 47.2 justiert. Das bestückte Modul ist in Fig. 15 dargestellt.

Als Lotmaterial wird bevorzugt eutektisches PbSn verwendet. Das bestückte Modul wird anschließend in einem Durchlaufofen mit Infrarotheizung verlötet. Nach dem Löten werden Flußmittelreste durch Waschen in Lösungsmittel entfernt. Das Modul wird schließlich in bekannter Weise mit einer Vergußmasse 39 bis zu einer in Fig. 16 erkennbaren Füllhöhe, d.h. etwas unterhalb des oberen Gehäuserandes, gefüllt. Fig. 16 zeigt das fertige Modul.

## Patentansprüche

1. Leistungshalbleitermodul mit
- einem Kunststoffgehäuse,
- einem in die Bodenfläche des Kunststoffgehäuses eingesetzten elektrisch isolierfähigen Substrat als Träger für elektrische Bauteile, das wenigstens auf der Oberseite mit einer Metallisierung versehen ist, wobei die Metallisierung auf der Oberseite zu Leiterbahnen strukturiert ist,
- auf die strukturierte Metallisierung aufgelöteten Bauteilen, wie Halbleiterbauelementen und Anschlußelementen,
dadurch gekennzeichnet, daß die Seitenwände des Kunststoffgehäuses (10,45) durch Anformungen gebildete Führungsschächte (11) oder Ausnehmungen (47.1,47.2) aufweisen, die der Führung und Positionierung von Bestückungsteilen (12,41,43,44), welche Anschlußlaschen (12) oder Stecker (41) umfassen, dienen und damit während der Modulherstellung als Lötform für diese Bestückungsteile (12,41,43,44) wirken.

2. Leistungshalbleitermodul nach Anspruch 1, dadurch gekennzeichnet, daß das Gehäuse (10,45) aus einem temperaturbeständigen Kunststoff besteht, der zumindest einer Temperatur standhält, die für eine Lötung der Bestückungsteile am Substrat mit Weichlot erforderlich ist.

3. Leistungshalbleitermodul nach Anspruch 1 oder 2, dadurch gekennzeichnet, daß die Führungsschächte (11) in der Draufsicht kreuzförmig ausgeführt sind, mit einem breiten Schachtteil (15) zur Führung von Anschlußlaschen (12) und einem schmalen Schachtteil (14) zur Führung eines an die Anschlußlaschen (12) angeformten Verbindungsteils (27).

4. Leistungshalbleitermodul nach einem der vorstehenden Ansprüche, dadurch gekennzeichnet, daß das Kunststoffgehäuse unterteilt ist in einen die Seitenwände bildenden Gehäuserahmen (10) und einen Gehäusedeckel (17).

5. Leistungshalbleitermodul nach einem der vorstehenden Ansprüche, dadurch gekennzeichnet, daß zumindest der Gehäuserahmen (10) des Kunststoffgehäuses aus einem Kunststoff besteht, dessen Schmelzpunkt oberhalb von 200°C liegt bzw. dessen Glasübergangstemperatur oberhalb von 100°C liegt.

6. Leistungshalbleitermodul nach Anspruch 4 oder 5, dadurch gekennzeichnet, daß zur Bildung von Steueranschlüssen (4) Stecker (29) mit einem angeschweißten Drahtstück (32) vorgesehen sind, wobei die Stecker (29) für die Steueranschlüsse (4) in Taschen (23) des Gehäuserahmens (10) eingesteckt sind.

7. Leistungshalbleitermodul nach einem der vorstehenden Ansprüche, dadurch gekennzeichnet, daß das Substrat ein Keramiksubstrat (5) ist.

8. Leistungshalbleitermodul nach einem der Ansprüche 1 bis 6, dadurch gekennzeichnet, daß ein Substrat (35) aus Metall vorgesehen ist mit einer elektrischen Isolierschicht (36), auf die Leiterbahnen aus Kupfer (37) aufgebracht sind.

9. Verfahren zur Herstellung eines Leistungshalbleitermoduls nach einem der Ansprüche 6 und 7, das die nachstehenden Verfahrensschritte umfaßt:
a) Bestücken und Verlöten des Substrats (5) mit Halbleiterbauelementen (1,2) und Herstellen der erforderlichen internen Verbindungen (8,9) in einem ersten Lötschritt,
b) Einkleben des bestückten Substrats in eine Ausnehmung (21) in der Bodenfläche des Gehäuserahmens (10) aus temperaturbeständigem Kunststoff,
c) Einsetzen von Anschlußlaschen (12) in Führungsschächte (11) des Gehäuserahmens (10), wobei die Anschlußlaschen (12) an einem Lötanschlußteil (28) gegebenenfalls mit Lötpaste versehen sind und mit diesem Anschlußteil (28) auf vorgesehenen und gegebenenfalls vorbeloteten Flächen (7) auf der aus Kupferflächen (6) bestehenden Metallisierung aufliegen, und Einsetzen von Steckern (29) in Taschen (23) des Gehäuserahmens (10), wobei an die Stecker (29) Verbindungsleitungen (32) angeformt oder angeschweißt sind, deren freies Ende (33) gegebenenfalls mit Lotpaste versehen ist und auf einer gegebenenfalls vorbeloteten Fläche (7) auf der Metallisierung aufliegt,
d) Durchführung einer zweiten Lötung mit einer solchen Temperaturführung, daß die Lötungen des ersten Lötschrittes nicht wieder aufschmelzen,
e) Vergießen des Moduls und Aufsetzen eines Gehäusedeckels (17).

10. Verfahren zur Herstellung eines Leistungshalbleitermoduls nach Anspruch 2 oder 8, das die nachstehenden Verfahrensschritte umfaßt:
a) Bedrucken eines lötbar metallisierten Substrats (35) mit einer Lotpaste (40),
b) Einkleben des bedruckten Substrats (35) in das temperaturbeständige Kunststoffgehäuse (45),
c) Bestücken des mit dem Gehäuse (45) verklebten Substrats (35) mit Bestückungsteilen (41,43,44) durch Einsetzen der Bestückungsteile (41,43,44) in Ausnehmungen (47.1,47.2) des Gehäuses,
d) Durchführung eines Lötprozesses,
e) Vergießen des Moduls.

## Claims

1. Power semiconductor module having
- a plastic housing,
- an electrically insulating substrate, inserted in the bottom face of the plastic housing, as carrier for electrical components which is provided at least on the upper side with a metallisation, the metallisation on the upper side being patterned to form conductor tracks,
- components, such as semiconductor components and connecting elements, soldered onto the patterned metallisation,
characterised in that the side walls of the plastic housing (10, 45) have locating compartments (11) formed by moulded-on sections, or recesses (47.1, 47.2), which serve to locate and position component parts (12, 41, 43, 44), which comprise connecting lugs (12) or plug connectors (41), and thus act as soldering jig for these component parts (12, 41, 43, 44) during the module production.

2. Power semiconductor module according to Claim 1, characterised in that the housing (10, 45) consists of a temperature-resistant plastic which withstands at least a temperature which is necessary for soldering the component parts to the substrate with soft solder.

3. Power semiconductor module according to Claim 1 or 2, characterised in that the locating compartments (11) are of cross-shaped structure in plan view, having a wide compartment part (15) for locating connecting lugs (12) and a narrow compartment part (14) for locating a connecting part (27) moulded onto the connecting lugs (12).

4. Power semiconductor module according to one of the preceding claims, characterised in that the plastic housing is subdivided into a housing frame (10), which forms the side walls, and a housing cover (17).

5. Power semiconductor module according to one of the preceding claims, characterised in that at least the housing frame (10) of the plastic housing consists of a plastic whose melting point is above 200°C or whose glass transition temperature is above 100°C.

6. Power semiconductor module according to Claim 4 or 5, characterised in that the plug connectors (29) are provided with a welded-on piece of wire (32) for forming control terminals (4), the plug connectors (29) for the control terminals (4) being inserted in pockets (23) of the housing frame (10).

7. Power semiconductor module according to one of the preceding claims, characterised in that the substrate is a ceramic substrate (5).

8. Power semiconductor module according to one of Claims 1 to 6, characterised in that a metal substrate (35) is provided with an electrical insulating layer (36) to which copper conductor tracks (37) are applied.

9. Method for producing a power semiconductor module according to one of Claims 6 to 7, comprising the following method steps:
a) Mounting and soldering semiconductor components (1, 2) on the substrate (5) and producing the necessary internal connections (8, 9) in a first soldering step,
b) Cementing the substrate with components mounted on it in a recess (21) in the bottom face of the housing frame (10) composed of temperature-resistant plastic,
c) Insertion of connecting lugs (12) in locating compartments (11) of the housing frame (10), a solder joint part (28) of the connecting lugs (12) optionally being provided with solder paste and said joint part (28) being up against provided areas (7), optionally covered with solder beforehand, on the metallisation consisting of copper areas (6), and inserting plug connectors (29) in pockets (23) of the housing frame (10), connecting leads (32) being moulded onto or welded onto the plug connectors (29) whose free end (33) is optionally provided with solder paste and is up against an area (7), optionally covered with solder beforehand, on the metallisation,
d) Carrying out a second soldering with such a temperature control that the solderings of the first soldering step do not remelt,
e) Encapsulating the module and mounting a housing cover (17).

10. Method for producing a power semiconductor module according to Claim 2 or 8, comprising the following method steps:
a) Printing of a solderable metallised substrate (35) with a solder paste (40),
b) Cementing the printed substrate (35) into the temperature-resistant plastic housing (45),
c) Mounting component parts (41, 43, 44) on the substrate (35) cemented to the housing (45) by inserting the component parts (41, 43, 44) in recesses (47.1, 47.2) in the housing,
d) Carrying out a soldering process,
e) Encapsulating the module.

## Revendications

1. Module de puissance à semi-conducteurs comportant
- un boîtier en matière plastique,
- un substrat électriquement isolant monté dans le fond du boîtier en plastique comme support de composants électriques, lequel substrat est pourvu sur sa face supérieure au moins d'une métallisation, la métallisation de la face supérieure étant agencée en pistes conductrices,
- des composants soudés sur la métallisation structurée, tels que des composants semi-conducteurs et des éléments de connexion,
caractérisé par le fait que les parois latérales du boîtier (10, 45) en matière plastique présentent des puits de guidage (11) ou des évidements (47.1, 47.2) qui sont destinés au guidage et au positionnement d'éléments d'équipement (12, 41 43, 44) qui englobent des pattes de connexion (12) ou des fiches (41) et, lors de la fabrication du module servent de préforme de soudage pour lesdits éléments d'équipement (12, 41, 43, 44).

2. Module de puissance à semi-conducteurs selon la revendication 1, caractérisé par le fait que le boîtier (10, 45) est en matériau résistant à la température, lequel matériau résiste au moins à la température nécessaire pour le soudage des éléments d'équipement sur le substrat à l'aide d'une soudure tendre.

3. Module de puissance à semi-conducteurs selon la revendication 1 ou 2, caractérisé par le fait que les puits de guidage (11), en vue de dessus, ont la forme d'une croix avec une partie (15) large pour le guidage de pattes de connexion (12) et une partie (14) étroite pour le guidage d'un élément de liaison (27) agencé sur les pattes de connexion (12).

4. Module de puissance à semi-conducteurs selon l'une des revendications précédentes, caractérisé par le fait que le boîtier en matière plastique est subdivisé en un châssis (10) qui constitue les parois latérales et en un couvercle (17).

5. Module de puissance à semi-conducteurs selon l'une des revendications précédentes, caractérisé par le fait que le châssis (10) du boîtier en matière plastique est réalisé en une matière plastique dont le point de fusion est supérieur à 200 °C ou dont la température de transition vitreuse est supérieure à 100 °C.

6. Module de puissance à semi-conducteurs selon la revendication 4 ou 5, caractérisé par le fait qu'il est prévu, pour former des branchements de commande (4), des fiches (29) sur lesquelles est soudé un morceau de fil (32), les fiches (29) des branchements de commande (4) étant montées dans des logements (23) du châssis (10) de boîtier.

7. Module de puissance à semi-conducteurs selon l'une des revendications précédentes, caractérisé par le fait que le substrat est un substrat céramique (5).

8. Module de puissance à semi-conducteurs selon l'une des revendications précédentes, caractérisé par le fait qu'il est prévu un substrat (35) en métal pourvu d'une couche (36) électriquement isolante sur laquelle sont appliquées les pistes conductrices (37) en cuivre.

9. Procédé de fabrication d'un module de puissance à semi-conducteurs selon l'une des revendications 6 et 7, comprenant les étapes suivantes:
a) mise en place et soudage de composants semi-conducteurs (1, 2) sur le substrat (5) et réalisation des liaisons (8, 9) intemes nécessaires au cours d'une première étape de soudage,
b) collage du substrat équipé dans un logement (21) du fond du châssis (10) de boîtier en matière plastique résistante à la température,
c) mise en place de pattes de connexion (12) dans des puits de guidage (11) du châssis (10), les pattes de connexion (12) étant éventuellement enduites de pâte à souder au niveau d'une partie (28) de connexion et venant en appui par ladite partie (28) sur des surfaces (7) prévues à cet effet et éventuellement préalablement enduites de soudure de la métallisation constituée de surfaces de cuivre (6), mise en place de fiches (29) dans des logements (23) du châssis (10) de boîtier, des fils de liaison (32) dont l'extrémité libre (33) est éventuellement enduite de pâte à souder et vient en contact avec une surface (7) éventuellement préalablement enduite de soudure de la métallisation étant formés ou soudés sur lesdites fiches (29),
d) réalisation d'une deuxième soudure à une température telle que les soudures réalisées au cours de la première étape ne fondent pas,
e) scellement du module et mise en place d'un couvercle (17).

10. Procédé de fabrication d'un module de puissance à semi-conducteurs selon l'une des revendications 2 et 8, comprenant les étapes suivantes:
a) enduction d'un substrat (35) métallisé soudable avec une pâte à souder (40),
b) collage du substrat enduit (35) dans le boîtier (45) en matière plastique résistante à la température,
c) équipement du substrat (35) collé dans le boîtier (45) avec des éléments d'équipement (41, 43, 44) par mise en place des éléments d'équipement (41, 43, 44) dans des logements (47.1, 47.2) du boîtier,
d) réalisation d'une étape de soudage,
e) scellement du module.
